(19) Europäisches Patentamt

European Patent Office

Office européen des brevets

(11) Numéro de publication: **0 347 992 B1**

(12) **FASCICULE DE BREVET EUROPEEN**

(45) Date de publication de fascicule du brevet: **01.06.94**

(51) Int. Cl.⁵: **H01L 21/308**, H01L 21/306

(21) Numéro de dépôt: **89201585.0**

(22) Date de dépôt: **19.06.89**

(54) **Procédé de réalisation de dispositifs semiconducteurs incluant au moins une étape de gravure ionique réactive.**

(30) Priorité: **24.06.88 FR 8808504**

(43) Date de publication de la demande:
**27.12.89 Bulletin 89/52**

(45) Mention de la délivrance du brevet:
**01.06.94 Bulletin 94/22**

(84) Etats contractants désignés:
**DE FR GB IT NL**

(56) Documents cités:

ELECTRONICS LETTERS, vol. 23, no. 16, 30 juillet 1987, pages 857-859; R. CHEUNG et al.: "Reactive ion etching of GaAs using a mixture or methane and hydrogen"

JOURNAL OF VACUUM SCIENCE & TECHNO-LOGY B, vol. 4, no. 1, "Second Series", janvier-février 1986, pages 341-344, American Vacuum Society, New York, NY, US; S.W. PANG et al.: "Sub-100-nm-wide, deep trenches defined by reactive ion etching"

(73) Titulaire: **LABORATOIRES D'ELECTRONIQUE PHILIPS**
**3, Avenue Descartes**
**F-94450 Limeil-Brévannes(FR)**

(84) Etats contractants désignés:
**FR**

(73) Titulaire: **N.V. Philips' Gloeilampenfabrieken**
**Groenewoudseweg 1**
**NL-5621 BA Eindhoven(NL)**

(84) Etats contractants désignés:
**DE GB IT NL**

(72) Inventeur: **Autier, Philippe**
**Société Civile S.P.I.D.**
**209 rue de l'Université**
**F-75007 Paris(FR)**
Inventeur: **Auger, Jean-Marc**
**Société Civile S.P.I.D.**
**209 rue de l'Université**
**F-75007 Paris(FR)**

**APPLIED PHYSICS LETTERS, vol. 49, no. 19,** 10 novembre 1986, pages 1284-1286, American Institute of Physics, New York, US; A. SCHERER et al.: "Fabrication of small laterally patterned multiple quantum wells"

**JOURNAL OF VACUUM SCIENCE & TECHNO-LOGY B, vol. 5, no. 6, novembre/décembre** 1987, pages 1591-1598, American Vacuum Society, New York, NY., US; N. VODJDANI et al.: "Reactive ion etching of GaAs with high aspect ratios with Cl2-CH4-H2-Ar mixtures"

(74) Mandataire: **Landousy, Christian et al**
**Société Civile S.P.I.D.**
**156, Boulevard Haussmann**
**F-75008 Paris (FR)**

# Description

L'invention concerne un procédé de réalisation de dispositifs semiconducteurs incluant au moins une étape de gravure ionique réactive d'un substrat constitué par un agencement choisi parmi :

- une plaquette massive d'un composé semi-conducteur de formule générale $Ga_{1-x}In_xAs_{1-y}P_y$,
- une succession de couches de composés semiconducteurs, chacun de formules générales $Ga_{1-x}In_xAs_{1-y}P_y$, dans lesquelles x et y sont les concentrations et sont comprises entre 0 et 1,

ce procédé comprenant pour la mise en oeuvre de cette gravure un système de masquage dudit substrat coopérant avec un flux de gaz réactants.

L'invention trouve son application dans la réalisation de dispositifs intégrés sur des matériaux $A_{III}$-$B_V$, et notamment des dispositif opto-électroniques en des composés III-V incluant l'élément In.

En effet, le matériau InP et les autres composés III-V, notamment les composés III-V contenant l'élément In sont considérés comme des matériaux très attractifs pour réaliser les dispositifs opto-électroniques intégrés, fonctionnant à des longueurs d'onde élevées telles que $1,3\mu m$ et $1,55\mu m$ qui sont les standards actuels en télécommunication.

Mais, pour mettre en oeuvre ces dispositifs intégrés, il s'est avéré indispensable de mettre au point des techniques de gravure sèche, qui sont seules appropriées à permettre l'obtention de motifs microniques ou submicroniques.

Il est notamment demandé à ces méthodes de gravure sèche de fournir :

- des motifs à haute résolution,
- des motifs reproductibles,
- l'anisotropie de la gravure dans toutes les directions cristallographiques,
- la conservation de la morphologie de surface.

Des méthodes de gravure sèche par "gravure ionique réactive" ci-après dénommée RIE sont connues de l'état de la technique.

D'une façon générale, ces méthodes connues portent sur :

a) une technique de formation d'un masque pour permettre la gravure des motifs dans les ouvertures du masque ;

b) une associaiton de gaz réactants, ou un gaz réactant, qui coopère avec le choix des matériaux constituant le masque, pour réaliser une gravure sélective, c'est-à-dire réaliser la gravure du matériau masqué, typiquement un matériau III-V, contenant In, sans détériorer le masque.

En opto-électronique, les problèmes qui se posent actuellement, consistent généralement à chercher à réaliser des motifs submicroniques gravés sur une grande profondeur, au moins supérieure à 3 $\mu$m et le plus souvent de l'ordre de 7 $\mu$m.

Ces problèmes se posent dans le cas où l'on veut réaliser des guides courbes enterrés, présentant dans la partie courbe un sillon gravé destiné au confinement latéral. Ces problèmes se posent encore lorsque l'on veut réaliser un miroir constitué par un sillon formant une lame à faces parallèles disposé en travers de la section d'un guide de lumière enterré. Dans ce cas, il est particulièrement important d'obtenir un sillon gravé qui présente des flancs de gravure totalement plans, lisses et perpendiculaires à l'axe du guide, c'est-à-dire au substrat.

De tels dispositifs sont décrits dans la publication intitulée "Probleme der Topographie integriert optischer Schaltungen" par Karl-Heinz TIETGEN dans " Frequenz, Vol. 35 (1981), sept n° 9, Berlin, Deutschland", publication qui n'enseigne pas de procédé de réalisation des dispositifs cités.

Ces problèmes se posent aussi, dans le cas de la réalisation de dispositifs opto-électroniques ou électroniques enterrés, où l'on veut obtenir l'accès à des couches profondes des dispositifs, par exemple l'accès au substrat lorsqu'il est recouvert d'un certain nombre de couches épitaxiales. Dans ce cas, il est particulièrement important d'obtenir un fond du puit de gravure très plan et très lisse, car ce plan est généralement destiné à servir de base pour de nouvelles couches épitaxiales.

Enfin, bien que les composés dits III-V présentent de nombreuses ressemblances, ils présentent aussi vis-à-vis des gaz réactants qui peuvent être utilisés en gravure sèche, de nombreuses dissemblances de nature chimique, qui sont dues notamment au fait qu'un de leurs éléments peut former, avec le gaz réactant en question, un composé volatil.

C'est pourquoi l'enseignement tiré de l'état de la technique, applicable à un composé III-V particulier, n'est pas systématiquement transposable à un autre composé III-V.

Un procédé de réalisation mettant en oeuvre une gravure sèche, du type RIE, visant à obtenir toutes les caractéristiques citées plus haut, est connu de la publication intitulée " A Novel Process for RIE on InP, using $CH_4/H_2$ par U. Niggebrügge, M. Klug, G. Garus dans "Inst-Phys. Conf. Ser. n° 79, chapter 6, paper presented at Int. Symp. GaAs and related compounds, KARUIZAWA, JAPAN - 1985".

Ce document décrit un procédé pour réaliser la gravure sèche par RIE du composé InP, utilisant le mélange de $CH_4$ et $H_2$ comme gaz réactants. Ce mélange est utilisé pour éviter les problèmes de corrosion du système à vide, et surtout parce que ces gaz permettent d'obtenir un taux de gravure du matériau InP de grandeur raisonnable. Avec des paramètres optimisés du mélange de gaz et de leurs conditions d'application, la méthode décrite permet d'obtenir des flancs de gravure présentant peu de rugosité et une pente de 85%, lors de la réalisation de guides à ruban.

Ces résultats on été obtenus par la coopération entre le choix des gaz réactants $CH_4/H_2$ avec un procédé de masquage consistant en la formation, pour les gravures profondes, d'une couche de $SiO_2$, qui peut être recouverte de photorésist, ou en la formation d'une couche de photorésist seule pour les gravures de faible profondeur. Cette publication enseigne l'effet étonnant de cette coopération gaz-masque qui consiste dans la formation en surface du masque d'une couche d'hydrures et de polymères, résultant en un durcissement du masque et en l'augmentation de sa résistance à l'érosion.

Ces éléments permettent d'éviter d'utiliser le chlore pur comme gaz réactant dans la gravure d'InP. En effet, l'utilisation du chlore est un inconvénient dans la gravure des composés contenant de l'indium, du fait qu'il réagit fortement avec l'indium et ne permet pas de contrôler correctement la gravure de ces composés.

D'autre part, l'effet étonnant de la formation d'une couche de durcissement d'hydrures en surface du masque en diélectrique permet d'éviter l'érosion latérale du masque, qui évidemment conduit, lorsqu'elle existe, à l'attaque de la partie supérieure des flancs de gravure et donc à une pente des flancs de gravure.

Malgré ces conditions optimisées et l'effet étonnant opéré sur le masque, les résultats obtenus par le procédé enseigné par cette publication ne sont pas suffisamment bons pour être applicables à la réalisation de dispositifs électrooptiques où l'on recherche une profondeur de gravure d'au moins 7μm et des flancs de gravure absolument perpendiculaires au substrat, pour des motifs submicroniques dans un composé III-V incluant l'indium (In). Notamment, la pente des flancs de gravure otenue de 85 % selon cette publication, est beaucoup trop importante si elle s'applique à des motifs submicroniques gravés sur une profondeur de 7μm. Cela est dû au fait que, lors d'une gravure aussi prolongée que celle qui permet d'obtenir une profondeur de 7μm, le masque en diélectrique est, malgré la formation de la couche d'hydrures, assez fortement attaqué latéralement pour entraîner que la pente des flancs de gravure devienne autre que 100 %. De plus, on a relevé que le fond des puits gravés selon la méthode enseignée par le document cité n'est pas suffisamment lisse pour permettre par exemple, le dépôt ultérieur d'autres couches.

Un procédé de réalisation, mettant en oeuvre une gravure sèche du type RIE, appliqué à l'attaque de GaAs, utilisant comme gaz réactants un mélange des gaz $Cl_2/CH_4/H_2/Ar$, est connu de la publication intitulée "Reactive ion etching of GaAS with high aspect ratios with $Cl_2$-$CH_4$-$H_2$-Ar mixtures" par N.Vodjdani et P.Parrens, dans "Journal of Vacuum Science and Technology, B5 (6), Nov/Dec 1987, pp. 1591-1598". Le procédé décrit dans ce document utilise un système de masquage formé d'une couche de $SiO_2$, de $Si_3N_4$ ou d'une résine recuite.

Un procédé de réalisation, mettant en oeuvre une gravure sèche, non pas du type RIE mais d'un type voisin, visant à obtenir toutes les caractéristiques techniques citées plus haut, mais appliquée à des composés autres que InP ou les composés contenant In, est connu de la publication intitulée "GaAs and GaAlAs anisotropic fine pattern etching using a new reactive ion beam etching system" par K. ASAKAWA and S. SUGATA, dans "J. Vac. Sci-Technol. B3 (1), Jan/Feb 1985, pp. 402-405".

Ce document décrit un procédé pour réaliser une gravure sèche au moyen d'un dispositif dit RIBE, par érosion ionique, utilisant le gaz $Cl_2$ pur pour graver les composés GaAs, ou les hétérostructures GaAs/GaAlAs.

Ce document enseigne que les pricnipaux problèmes apparaissant lors de la gravure, sont dûs à l'érosion du masque en cours de gravure. En conséquence, ce document décrit la constitution d'un masque très élaboré, en trois couches. La première couche est une couche en résine Az, recuite à 250°C. La seconde est une couche de titane, et la troisième est une couche de résine Az recuite à 90°C. La complexité de ce masque vise à éviter son érosion lors de la gravure dans le gaz $Cl_2$ pur. En effet, la couche de résine Az, lorsqu'elle est recuite à 90°C est sensible à l'érosion lors de la gravure, par contre lorsquelle est recuite à 250°C, elle devient très résistante. Cependant, il existe de difficultés pour réaliser le recuit de la résine à 250°C. Ces difficultés résident dans le fait que vers 135°C elle devient fluente. D'où la nécessité de la couche de titane en surface de cette couche Az pour maintenir durant le recuit une surface supérieure plane.

Cependant le document cité ne dévoile pas le procédé exact qui permet d'obtenir la couche recuite à 250°C coexistant avec la couche de Ti et la couche recuite à 90°C. Il y a tout lieu de croire que le procédé doit être fait pas à pas pour éviter la présence de la troisième couche (à recuire à 90°C) lors du recuit de la première couche à 250°C.

Et si cette publication enseigne que les résultats de gravure obtenus avec ce masque en trois couches coopérant avec le gaz $Cl_2$ sont très bons pour GaAs et les composés dépourvus d'indium, notamment les résultats concernant une profondeur

de gravure de 7μm, des flancs de gravure parfaitement perpendiculaires au substrat, des motifs microniques, cette publication n'enseigne pas à obtenir ces mêmes résultats sur un composé contenant l'indium (In). Or on a vu que l'on ne pouvait pas graver un tel composé contenant l'indium au moyen de chlore pur.

D'autre part, il s'avère que la mise en oeuvre de ce masque en trois couches, sur un plan industriel, procure un trop faible rendement de fabrication pour être envisagée, ceci étant dû à la complexité de réalisation dudit masque.

C'est pourquoi, la présente invention vise à fournir un procédé de réalisation qui permet d'obtenir des gravures profondes d'au moins 7μm, des flancs de gravure lisses et parfaitement perpendiculaires au substrat, des motifs microniques, et même submicroniques (0,7μm), applicable aussi bien aux composé III-V tels que GaAs qu'aux composés III-V inclant l'élément In tels que InP.

Selon l'invention, ce but est atteint au moyen du procédé défini dans le préambule de la revendication 1, caractérisé en ce que le système de masquage est formé d'une première couche métallique de titane (Ti) de faible épaisseur, surmontée d'une seconde couche métallique de Nickel (Ni) environ 10 fois plus épaisse, et en ce que le flux de gaz réactants est formé du mélange des gaz $Cl_2/CH_4/H_2/Ar$, mélange dans lequel $Cl_2$ est dans les proportions d'environ le quart de celle de $CH_4$ et de celle de Ar, en ce qui concerne les pressions partielles dans la chambre de gravure.

L'invention sera mieux comprise au moyen de la description suivante illustrée par les figures annexées dont :

- les figures 1a à 1f qui montrent en coupe simplifiée, un dispositif dans les différentes étapes d'une gravure selon l'invention,
- la figure 2 qui montre en perspective une réalisation expérimentale mettant en lumière les performances du procédé selon l'invention.

Comme on l'a dit plus haut, le but de l'invention est de fournir un procédé de masquage, coopérant avec un ou des gaz réactants lors de la gravure, qui permet d'obtenir avec un rendement de fabrication rentable industriellement, c'est-à-dire qui conduit à réussir, avec un faible pourcentage de déchets :

- la gravure de tous composés III-V allant de GaAs à InP en passant par les composés $Ga_{1-x}In_xAs_{1-y}P_y$,
- des motifs de 0,5 à 1μm en moyenne 0,7μm,
- des profondeurs de gravure de 7μm au moins,
- des flancs de gravure parfaitement perpendiculaire au substrat (pente 100 %),

- des flancs lisses et des fonds de gravure lisses,
- des taux de gravure élevés, point important sur le plan industriel,
- des masques faciles à mettre en oeuvre,
- un procédé qui comporte le moins d'étapes possible, point également important sur le plan industriel.

Ces buts sont atteints si l'on fait coopérer la formation d'un masque en deux couches consistant en une couche 1 de titane (Ti) surmontée d'une couche 2 de nickel (Ni), avec l'utilisation dans la méthode RIE de composés chlorés et non pas de chlore pur.

De préférence, l'invention sera mise en oeuvre par la succession des étapes décrites ci-après :

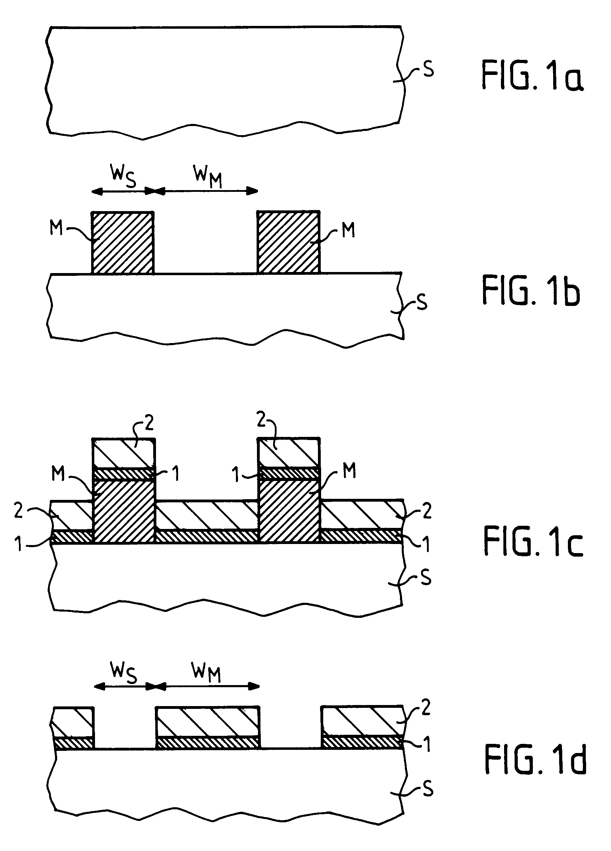

a) Préparation d'une plaquette S d'un substrat à graver. Ce peut être toute plaquette d'un composé semiconducteur du groupe III-V, de formule générale $Ga_{1-x}In_xAs_{1-y}P_y$, où x et y sont des concentrations comprises entre 0 et 1 (voir la figure 1a). Ce peut être aussi une alternance de couches de ces matériaux, réalisées par exemple par épitaxie, et formant des homostructures ou des hétérostructures.

b) Réalisation au moyen d'une résine photosensible d'un masque M présentant des ouvertures disposées en surface des régions du substrat qui doivent être protégées durant la gravure ionique réactive ; ces ouvertures sont donc disposées dans les régions qui seront ultérieurement masquées pour la RIE (voir la figure 1b).

Comme résines photosensibles on pourra choisir la Az4070, ou Az 5214, ou la RD 2000N, car ces produits sont des laques négatives qui permettent d'éliminer les liserés habituels des laques positives classiques. On lira à ce sujet avec profit, la publication de "West and alii, Jour. Vac. Sci. Technol B5(1), 1987, pp 449-453".

Avec de telles résines, on peut définir par les méthodes de photolithographie connues de l'homme du métier, des motifs de dimension 0,5 à 1μm.

On pourra réaliser, par exemple, à titre expérimental, des réseaux montrant des sillons de 1,3μm de large séparés par des murs de 0,7μm d'épaisseur, ou bien le contraire, ou bien des réseaux de murs et sillons alternés de l'ordre de lμm chacun, et d'une manière générale des réseaux dont un élément est micronique ou submicronique, au pas de l'ordre de 2μm.

Pour l'application aux circuits intégrés optoélectroniques toute autre forme de motifs microniques ou submicroniques pourra alors être réalisée, grâce aux performances obtenues.

Ainsi dans l'exemple de réalisation illustré par les coupes 1a à 1f, on a choisi de faire un réseau montrant des sillons de $W_S$ = 0,7$\mu$m et des murs de $W_M$ = 1,3$\mu$m.

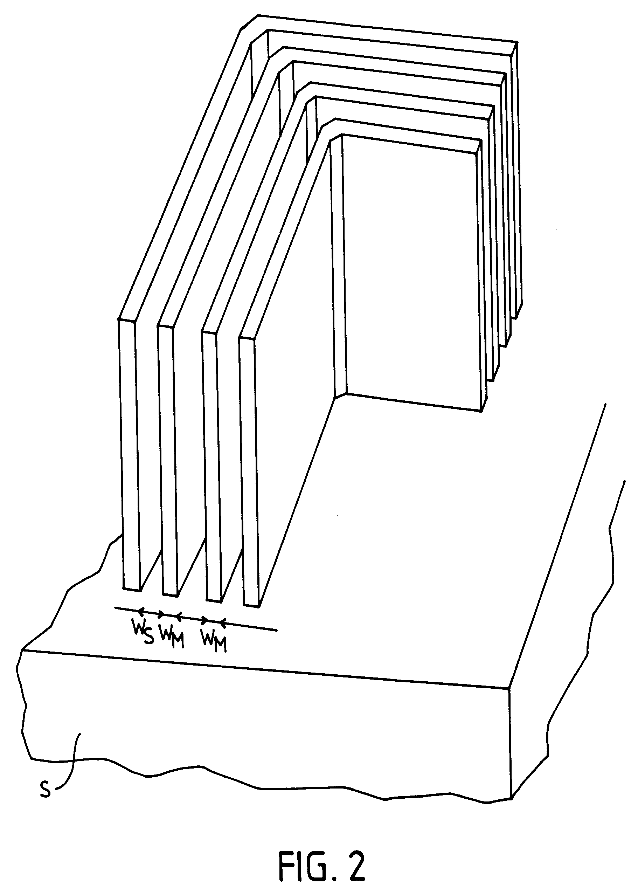

Dans l'exemple de réalisation illustrée par la figure 2 en perspective, on a au contraire réalisé des sillons de $W_S$ = 1,3 et des murs de $W_M$ = 0,7$\mu$m. On a même réalisé un motif complexe où les murs tournent d'un angle de 90°.

Dans l'un et l'autre de ces exemples la profondeur de gravure est p = 7$\mu$m.

Ce motif est réalisé, à cette étape, en négatif, au moyen de la résine choisie, comme montré sur la figure 1b. Pour graver des motifs submicroniques, l'épaisseur de la résine déposée doit être $e_M \simeq$ 0,7$\mu$m.

c) Dépôt par évaporation sous vide, au moyen d'un canon à électrons, d'une première couche métallique 1 de titane (Ti) d'épaisseur $e_1$ comprise entre 30 et 50 nm, suivi, dans la même chambre d'évaporation, en changeant simplement de cible, du dépôt d'une seconde couche métallique 2 de nickel (Ni) d'épaisseur $e_2$ comprise entre 200 et 300 nm, c'est-à-dire environ 8 à 10 fois plus épaisse que la première couche métallique 1 (voir la figure 1c).

Cependant les épaisseurs $e_1$ et $e_2$ sont choisies pour que la somme des épaisseurs $e_1 + e_2 < e_M$, de manière à pouvoir attaquer aisément la couche M dans une étape ultérieure (voir la figure 1c).

La superposition des deux couches métalliques 1 et 2 va constituer le système de masquage pour l'étape de gravure ionique réactive, selon l'invention. Les avantages de ce système de masquage sont :

- la simplicité de réalisation = une simple évaporation sous vide, en une seule opération, de deux métaux courants, excluant des recuits critiques ou des opérations qui ne s'enchaînent pas comme il était enseigné par l'état de la technique.
- la résistance mécanique à tout gaz réactant. Cet avantage apparaît à partir du document cité qui enseigne que le titane est gravé par le chlore pur. Ici, la couche de titane, placée en sous-couche, et dont le rôle sera décrit plus loin, est limitée à une très faible épaisseur car le titane donne avec le chlore des composés $TiCl_2$ volatils. La couche de nickel placée en couche supérieure, et dont l'épaisseur est prépondérante puisque environ 10 fois supérieure à celle de la couche de titane, présente au contraire une résistance à l'érosion très grande, notamment vis-à-vis du chlore, et aussi bien à l'érosion verticale qu'à l'érosion latérale.

d) Elimination de la couche M en résine, par exemple par l'acétone à ébullition, permettant le lift-off des portions indésirables de couche 1 et 2, qui se sont déposées en surface des portions de couche M (voir la figure 1d).

e) Gravure du matériau semiconducteur, dit substrat S, dans les ouvertures du masque formé par les couches 1 et 2 superposées. Cette gravure est opérée selon l'invention par une gravure de type RIE, connue en soi de l'homme du métier, au moyen de gaz qui sont choisis selon l'invention dans le mélange suivant : $Cl_2/CH_4/H_2/Ar$,
ces gaz agissant aux pressions partielles de 1 - 4 - 24 - 4 pour chacun d'eux respectivement dans le mélange.

La puissance est 120 watts.

La pression totale de gaz est 5 Pa (40 m torrs).

Ce mélange de gaz a été choisi spécialement pour coopérer avec la constitution des couches 1 et 2 pour atteindre les buts de l'invention.

En effet comme on l'a vu, si l'on veut graver un composé contenant l'élément In, l'emploi du chlore pur est exclu. Ce gaz employé à l'état pur n'est compatible qu'avec la gravure de GaAs comme il est enseigné par le second document décrit au titre d'état de la technique.

D'autre part, le choix de $CH_4/H_2$ comme gaz de gravure d'InP et connu du premier document cité conduit à des taux de gravure trop faibles pour les applications industrielles. En fabrication, les taux de gravure doivent être élevés, sans que la rapidité de fabrication ne nuise à la qualité. On verra que la sélection opérée selon l'invention dans les concentrations ou pression partielle des gaz réactants conduit à un taux de gravure élevé et en même temps à une qualité de fabrication excellente d'où un haut rendement de fabrication.

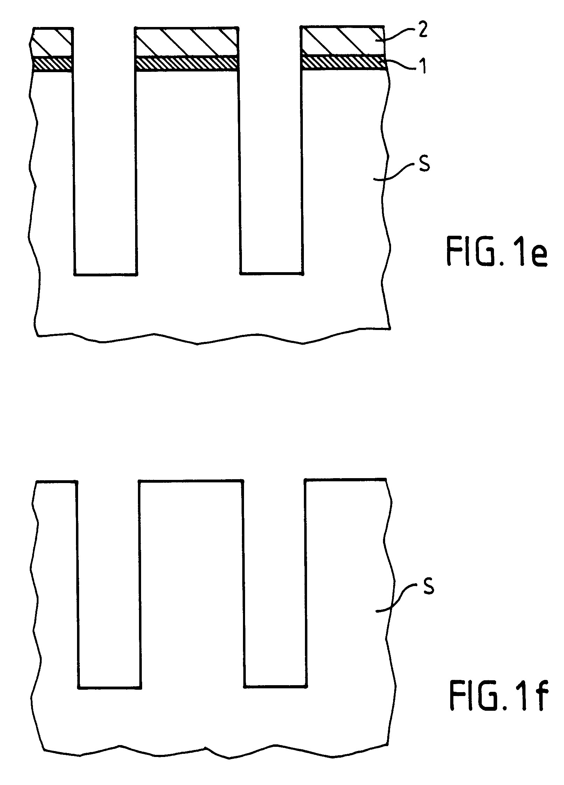

La gravure peut être pratiquée sur une profondeur de 7$\mu$m sans nuire à la qualité attendue (voir les figures 1e et 2).

f) Lift-off des couches métalliques 1 et 2 formant le système de masquage précédemment utilisé pour l'étape de gravure RIE. C'est dans cette étape de lifft-off que la couche 1 de titane joue un rôle. En effet, si le nickel formant la couche 2, est fort difficile à éliminer par des acides choisis par ailleurs pour ne pas détériorer la surface du substrat, en revanche la couche de titane, même recouverte de l'épaisse couche de nickel, s'élimine en 3 à 10 mn dans l'acide fluorhydrique pur ou légèrement dilué, et à température ordinaire. L'élimination de la couche 1 de titane entraine alors l'élimination de la couche 2 de nickel (voir la figure 1f).

Vu le rôle joué par la couche de titane, l'invention peut être mise en oeuvre en remplaçant, pour la couche 1, la titane par tout métal ayant les mêmes propriétés, c'est-à-dire présentant un dépôt simple s'éliminant facilement dans l'acide fluorhydrique ou un autre acide n'attaquant pas le substrat et présentant une résistance suffisante au mélange de gaz $Cl_2/CH_4/H_2/Ar$ utilisé pour l'étape de RIE.

De même le nickel peut être remplacé, pour constituer la seconde couche métallique par tout métal ayant les mêmes propriétés à savoir la simplicité du dépôt et la grande résistance à l'érosion par le mélange de gaz préconisé.

**Revendications**

1. Procédé de réalisation de dispositifs semiconducteurs, comprenant au moins une étape de gravure ionique réactive d'un substrat constitué par un agencement choisi parmi :
   - une plaquette massive d'un composé semiconducteur de formule générale $Ga_{1-x}In_xAs_{1-y}P_y$,
   - une succession de couches de composés semiconducteurs, chacun de formules générales $Ga_{1-x}In_xAs_{1-y}P_y$, dans lesquelles x et y sont les concentrations et sont comprises entre 0 et 1,
   
   ce procédé comprenant pour la mise en oeuvre de cette gravure un système de masquage dudit substrat coopérant avec un flux de gaz réactants,
   caractérisé en ce que le système de masquage est formé d'une première couche métallique de titane de faible épaisseur, surmontée d'une seconde couche métallique de Nickel environ 10 fois plus épaisse, et en ce que le flux de gaz réactants est formé du mélange des gaz $Cl_2/CH_4/H_2/Ar$, mélange dans lequel $Cl_2$ est dans les proportions d'environ le quart de celle de $CH_4$ et de celle de Ar, en ce qui concerne les pressions partielles,< dans la chambre de gravure.

2. Procédé de réalisation selon la revendication 1 dans lequel le système de masquage et le mélange de gaz sont mis en oeuvre selon la succession d'étapes suivantes :
   a) formation d'un substrat semiconducteur (S) choisi parmi une plaquette de composé $Ga_{1-x}In_xAs_{1-y}P_y$ ou une telle plaquette en outre munie de couches épitaxiales de tels composés dans la formule générale desquels x et y sont les concentrations comprises entre 0 et 1 ;
   b) dépôt en surface dudit substrat d'une couche (M) d'une résine négative, et formation par photolithographie, dans cette résine, d'ouvertures disposées en coincidence avec les régions du substrat (S) qui doivent être protégées durant la gravure, pour constituer des motifs prédéterminés, l'épaisseur de la couche (M) étant de l'ordre de $0,7\mu m$ ;
   c) dépôt par évaporation sous vide de la première couche métallique en titane d'épaisseur environ 30 à 50 nm, suivi du dépôt par exemple dans la même chambre, par évaporation sous vide, de la seconde couche métallique en nickel, environ 10 fois plus épaisse que la première couche métallique, c'est-à-dire d'environ 300 à 500 nm ;
   d) élimination de la couche (M) en résine, par exemple au moyen d'acétone bouillante, entraînant les portions de la première couche métallique et de la seconde couche métallique indésirables, et faisant apparaître dans le système formé par la superposition des deux couches métalliques, des ouvertures disposées en coïncidence avec les régions du substrat qui doivent être gravées, constituant ainsi le système de masquage dudit substrat (S) pour la gravure ionique réactive;
   e) gravure dudit substrat (S), à travers les ouvertures du système de masquage ainsi constitué, par une méthode de gravure ionique réactive, au moyen du mélange du gaz $Cl_2/CH_4/H_2/Ar$ dont les pressions partielles sont dans les proportions respectives 1 - 4 - 24 - 4.
   f) élimination desdites première et seconde couches métalliques formant le système de masquage par une méthode dite lift-off, consistant en l'attaque de la première couche métallique de titane au moyen d'acide fluorhydrique pur ou légèrement dilué, à température ambiante, pendant 3 à 10 mn, l'élimination de la première couche métallique entraînant en même temps celle de la seconde.

**Claims**

1. A method of manufacturing semiconductor devices including at least a reactive ion etching step of a substrate which constituted by a arrangement chosen among:
   - a solid wafer of a semiconductor compound having the general formula $Ga_{1-x}As_xIn_{1-y}P_y$,
   - a succession of layers of semiconductor compounds each having the general formula $Ga_{1-x}As_xIn_{1-y}P_y$ in which formulae $\underline{x}$ and $\underline{y}$ are the concentrations and lie between O and 1, this method comprising a masking system of the said substrate cooperating with a flow of reacting gases so as to carry out this etching step,

characterized in that the masking system is formed by a first metal layer of titanium of small thickness, on which is disposed a second metal layer of nickel which is approximately ten times thicker, and in that the flow of reactive gases is formed by the mixture of the gases $Cl_2/CH_4/H_2/Ar$, in which mixture $Cl_2$ is present in a quantity of approximately a quarter of the quantity of $CH_4$ and of that of Ar as far as the partial pressures in the etching chamber are concerned.

2. A method of manufacturing as claimed in Claim 1, in which the masking system and the gas mixture are obtained by the succession of the following steps:

a) forming a semiconductor substrate (S) chosen among a wafer of a compound $Ga_{1-x}As_xIn_{1-y}P_y$ or such a wafer moreover provided with epitaxial layers of such compounds, in whose general formula x and y are concentrations lying between O and 1;

b) depositing at the surface of the said substrate a layer (M) of a negative resin and forming by photolithography in this resin openings disposed in coincidence with the regions of the substrate (S) which must be protected during the etching treatment so as to form predetermined patterns, the thickness of the layer (M) being of the order of 0.7 $\mu$m;

c) depositing by evaporation in vacuo the first metal layer of titanium having a thickness of approximately 30 to 50 nm, followed by depositing, for example in the same chamber, by evaporation in vacuo a second metal layer of nickel approximately eight to ten times thicker than the first metal layer, i.e. approximately 300 to 500 nm;

d) eliminating the layer (M) of resin, for example by means of boiling acetone, taking along the undesired parts of the first metal layer and of the second metal layer and causing the appearance in the system formed by the superimposition of the two metal layers of openings disposed in coincidence with the regions of the substrate which must be etched, thus constituting the masking system of the said substrate (S) for the reactive ion etching treatment;

e) etching the said substrate (S) through the openings of the masking system thus constituted by a reactive ion etching method by means of the mixture of the gases $Cl_2/CH_4/H_2/Ar$, whose partial pressures are in the respective ratios 1-4-24-4;

f) eliminating the said first and second metal layers forming the masking system by a so-called lift-off method consisting in attacking the first metal layer of titanium by means of pure or slightly diluted hydrofluoride (HF) at ambient temperature for 3 to 10 minutes, the elimination of the first metal layer at the same time leading to the elimination of the second metal layer.

**Patentansprüche**

1. Verfahren zur Herstellung von Halbleiteranordnungen, das mindestens eine reaktive ionische Ätzstufe eines Substrats enthält, wobei dieses Substrat wie folgt aufgebaut sein kann:

- als massives Plättchen einer Halbleiterverbindung mit der allgemeinen chemischen Formel $Ga_{1-x}In_xAs_{1-y}P_y$, oder
- als Folge von Schichten von Halbleiterverbindungen jeweils mit der allgemeinen chemischen Formel $Ga_{1-x}In_xAs_{1-y}P_y$, wobei x und y in diesen Formeln die jeweiligen Stoffkonzentrationen bedeuten und Werte zwischen 0 und 1 annehmen können,

und wobei dieses Verfahren für die Durchführung der Ätzung ein Maskensystem für das Substrat enthält, das mit einem reaktiven Gasstrom zusammenwirkt; das Verfahren ist dadurch gekennzeichnet, daß das Maskensystem aus einer ersten, dünnen Metallschicht aus Titan besteht, über der eine zweite, etwa 10 mal stärkere Metallschicht aus Nickel liegt, und ist weiterhin dadurch gekennzeichnet, daß als reaktives Gas ein Gasgemisch aus $Cl_2/CH_4/H_2/Ar$ verwendet wird, wobei $Cl_2$ in dieser Mischung etwa ein Viertel des Anteils an $CH_4$ und an Ar ausmacht, was den partiellen Gasdruck in der Ätz-Vakuumkammer betrifft.

2. Herstellungsverfahren nach Anspruch 1, dadurch gekennzeichnet, daß das Maskensystem und das Ätzgasgemisch in der untengenannten Abfolge von Arbeitsschritten eingesetzt werden:

a) Bildung eines Halbleiter-Substrats (S) aus einem Plättchen einer Halbleiterverbindung $Ga_{1-x}In_xAs_{1-y}P_y$ oder aus einem Plättchen, das mit Epitaxie-Schichten dieser Verbindung versehen ist, wobei x und y in dieser allgemeinen Formel die jeweiligen Stoffkonzentrationen bedeuten und Werte zwischen 0 und 1 annehmen können;

b) Aufbringen auf der Substratoberfläche einer Schicht (M) eines negativen Harzes und Herstellung von Aussparungen in der Harzschicht mittels Photolithographie genau an denjenigen Stellen des Substrats (S), die während der Ätzung zu schützen sind, um daraus vorgegebene Strukturen zu bilden; die Stärke der Schicht (M) liegt dabei in der Größenordnung von $0,7 \mu m$;

c) Aufbringen durch Vakuumbedampfung der ersten Metallschicht aus Titan in einer Stärke zwischen 30nm und 50nm und daran anschließendes Aufbringen, beispielsweise in derselben Vakuumkammer, der zweiten etwa 10 mal stärkeren Metallschicht aus Nickel, d.h. in einer Stärke zwischen 300nm und 500nm;

d) Entfernen der Harzschicht (M), beispielsweise durch kochendes Azeton, wodurch die unerwünschten Teile der ersten und der zweiten Metallschicht mitentfernt werden und wodurch in den übereinanderliegenden beiden Metallschichten Aussparungen an denjenigen Substratstellen entstehen, die später zu ätzen sind und die somit auf dem Substrat (S) ein Maskensystem für die anschließende reaktive ionische Ätzstufe bilden;

e) Ätzen des Substrats (S) an den vom Maskensystem freigelassenen Stellen durch ein reaktives ionisches Ätzverfahren mittels eines Gemisches aus den Gasen $Cl_2/CH_4/H_2/Ar$, wobei diese Gase mit den jeweiligen Partialdrücken 1, 4, 24 und 4 am Gemisch beteiligt sind;

f) Entfernen der ersten und der zweiten Metallschicht des Maskensystems durch das sog. "Lift-off-Verfahren", bei dem die erste Schicht aus Titan innerhalb von 3 bis 10 Minuten und unter Raumtemperatur durch reine oder leicht verdünnte Fluorwasserstoffsäure entfernt wird und damit gleichzeitig die Ablösung der zweiten Metallschicht bewirkt.

FIG.1a

FIG.1b

FIG.1c

FIG.1d

FIG.1e

FIG.1f

FIG. 2